Europäisches Patentamt

European Patent Office

Office européen des brevets

(19)

(11) Veröffentlichungsnummer : **0 062 768
B1**

(12) # EUROPÄISCHE PATENTSCHRIFT

(45) Veröffentlichungstag der Patentschrift :
26.06.85

(21) Anmeldenummer : 82101915.5

(22) Anmeldetag : 10.03.82

(51) Int. Cl.⁴ : **H 03 K 21/40, H 03 K 5/15,
B 61 L 1/20, G 06 F 11/16**

(54) Schaltungsanordnung zur Überwachung von Schaltwerken.

(30) Priorität : 08.04.81 DE 3114230

(43) Veröffentlichungstag der Anmeldung :
20.10.82 Patentblatt 82/42

(45) Bekanntmachung des Hinweises auf die Patenterteilung : 26.06.85 Patentblatt 85/26

(84) Benannte Vertragsstaaten :
NL

(56) Entgegenhaltungen :
DE-A- 2 639 064
DE-B- 2 135 683
DE-B- 2 602 169
DE-B- 2 651 314
DE-B- 2 729 362
ELEKTRONIK, nr. 11, 1977 K. MEYER "Sicherheitssysteme für elektronisch gesteuerte Anlagen" Seiten
59 bis 64

(73) Patentinhaber : Siemens Aktiengesellschaft
Berlin und München Wittelsbacherplatz 2
D-8000 München 2 (DE)

(72) Erfinder : Strelow, Horst, Dipl.-Ing.
Magdeburgstrasse 13
D-3302 Weddel (DE)
Erfinder : Zeiler, Christoph, Ing. grad.
Luisenstrasse 15
D-3300 Braunschweig (DE)

## Beschreibung

Die Erfindung bezieht sich auf eine Schaltungsanordnung zur Überwachung von Schaltwerken, die in zwei Kanälen gleiche Daten taktversetzt verarbeiten und zu vorgegebenen Zeitpunkten über vergleichbare Ausgänge bei ordnungsgerechtem Betrieb gleiche Informationen abgeben, unter Verwendung einer Fehlererkennungsschaltung, die bei gestörtem Betrieb die Informationsausgabe verhindert, wobei die Fehlererkennungsschaltung mindestens einen Verstärker aufweist, dessen Stromversorgung über eine Gleichrichterschaltung erfolgt, die an einen Ausgang des einen Schaltwerkes und an den gleichen, jedoch negierten Ausgang des anderen Schaltwerkes angeschlossen ist.

Für digital arbeitende, elektronische Einrichtungen werden in zunehmendem Maße Hilfsschaltungen benötigt, die einen in einem taktgesteuerten Schaltwerk entstandenen Ausfall zuverlässig erkennbar machen. Dies gilt besonders auf dem Gebiet der Eisenbahnsicherungstechnik. In der DE-OS 26 39 064 wird als zu überwachendes Schaltwerk beispielsweise eine Schaltungsanordnung zur Überwachung und zur Erkennung von Fehlern in Zählschaltungen beschrieben. Wesentlich ist bei dieser bekannten Anordnung, daß zwei identisch aufgebaute Zählschaltungen vorgesehen sind, die durch Taktimpulse verschiedener Taktphasen eines gemeinsamen Systemtaktes steuerbar sind. In diesem Schaltungszusammenhang ist eine Fehlererkennungsschaltung vorgesehen, die aus mehreren speichernden Schaltgliedern und einem verknüpfenden Schaltglied aufgebaut ist. Durch diese zusätzliche Schaltungsmaßnahme wird erreicht, daß die die Zählfunktion eines der beiden Zähler beeinträchtigenden Ausfälle erkennbar werden.

Die bekannte Schaltung hat jedoch den Nachteil, daß sie unter neuerdings üblichen Fehlerannahmen für integrierte Schaltkreise nicht den gewünschten Sicherheitsanforderungen genügt. Dies liegt zum einen an dem Prinzip der bekannten Fehlererkennungsschaltung selbst und zum anderen daran, daß die Fehlererkennungsschaltung bei einem erkannten Zählerausfall die an den Zählereingängen wirksamen Taktimpulse nicht bereits in der Taktimpulsquelle blockieren kann.

Eine Schaltungsanordnung der eingangs angegebenen Art ist in der DE-AS 2 729 362 beschrieben. Das Besondere dieser Schaltungsanordnung liegt in einer Fehlererkennungsschaltung, die es bei einem taktversetzten Arbeiten zweier Datenverarbeitungsanlagen gestattet, Störungen zu erkennen, die auf beide Datenverarbeitungsanlagen gleichzeitig einwirkten. Dabei entstehen keine die Verarbeitungsgeschwindigkeit mindernden Verarbeitungslücken. Die Fehlererkennungsschaltung kann jedoch keinen Einfluß nehmen auf die die Datenverarbeitungsanlagen steuernden Taktimpulse in Form eines Abschaltvorganges bei unzulässigen Frequenzverschiebungen. Außerdem werden besondere Überwachungsimpulse benötigt.

Der Erfindung liegt somit die Aufgabe zugrunde, eine Schaltungsanordnung der eingangs angegebenen Gattung dahingehend zu verbessern, daß im Fehlerfall die zum Betrieb der beiden Schaltwerke erforderlichen Taktimpulse abgeschaltet werden, wobei gleichzeitig eine Überwachung der Taktimpulsfrequenz ermöglicht werden soll. Auf die für die Datenverarbeitung nicht erforderlichen Überwachungsimpulse soll verzichtet werden.

Erfindungsgemäß wird die Aufgabe dadurch gelöst, daß die Taktversorgung beider Schaltwerke über verschiedene Speicherglieder mindestens eines mehrstufigen Registers erfolgt, das ein eigenes Zeitnormal aufweist und über eine Torschaltung Impulse eines ein zweites Zeitnormal bildenden Taktgenerators erhält, deren Periodendauer der Gesamtlaufzeit des Registers entspricht, wobei ein an letzter Stelle des Registers vorgesehenes Speicherglied die Torschaltung über mindestens einen Verstärker der Fehlererkennungsschaltung mit Impulsen versorgt, deren Dauer größer ist als die Summe der Laufzeittoleranzen des Registers.

Diese Schaltungsanordnung kann nicht nur in vorteilhafter Weise zur Überwachung zweikanaliger Zählerschaltungen verwendet werden, sondern auch für beliebig andere gleich- oder ungleichartig aufgebaute digitale Schaltwerke, z. B. auch für Mikrocomputer. Dabei ist es durchaus vorteilhaft, nicht nur ein mehrstufiges Register zur Taktversorgung der Schaltwerke vorzusehen, sondern zwei mehrstufige Register, von denen jedes jeweils nur ein zugeordnetes Schaltwerk mit Taktimpulsen versorgt. Durch die vorteilhafte Verschmelzung einer Taktstromversorgung ohne besondere Überwachungssignale mit in zwei Kanälen arbeitenden Schaltwerken ist erreicht, daß die Taktimpulse mit Sicherheit nicht mehr erzeugt werden, wenn sich in einem der Schaltwerke ein Fehler einstellt.

Eine vorteilhafte Ausführungsform sieht vor, daß das mehrstufige Register aus einer vorgegebenen Anzahl in Reihe geschalteter bistabiler Speicherglieder besteht, die durch eine das Zeitnormal bildende gesonderte Taktstromquelle fortschaltbar sind.

Eine weitere vorteilhafte Ausführungsform der Erfindung sieht vor, daß das mehrstufige Register aus einer vorgegebenen Anzahl von monostabilen Kippgliedern als Speicherglieder besteht, derart, daß sich die Zeiten der instabilen Schaltlagen addieren, und daß zwischen dem Taktgenerator und das Register sowie zwischen das erste und zweite monostabile Kippglied des Registers ein erstes bzw. zweites durch die über den Verstärker geführten Impulse steuerbares D-Kippglied geschaltet ist, wobei das erste D-Kippglied zusammen mit einer an den Taktgenerator angeschlossenen Startschaltung über je ein verknüpfendes Schaltglied das erste monostabile Kippglied des Registers bzw. das zweite D-Kippglied steuert.

Aus der DE-AS 2 602 169 ist bereits eine Schaltungsanordnung zum zyklischen Erzeugen einer signaltechnisch sicheren Folge von Steuerimpulsen für Schaltwerke bekannt mit einem Quarzgenerator, der über eine Steuerschaltung eine Reihenschaltung aus Verzögerungsgliedern, z. B. monostabilen Kippstufen, mit Impulsen versorgt. Die sich durch Addition der Ablaufzeiten während der instabilen Zustände der einzelnen monostabilen Kippstufen ergebende Gesamtlaufzeit (erstes Zeitnormal) der Reihenschaltung ist dabei so gewählt, daß sie mit der Periodendauer (zweites Zeitnormal) des Quarzgenerators übereinstimmt. Die Gesamtschaltung erlaubt einen signaltechnisch sicheren Vergleich der beiden Zeitnormale, also Quarzgenerator-Periodendauer mit der Gesamtlaufzeit der Reihenschaltung. Eine Kopplung mit einem oder mehreren Schaltwerken, die mit signaltechnisch sicheren Folgen von Impulsen versorgt werden müssen, ist im Hinblick auf einen Abschaltvorgang der Taktstromversorgung bei einem etwaigen fehlerhaften Verhalten des Schaltwerkes nicht vorgesehen.

Ein Ausführungsbeispiel der Erfindung ist in der Zeichnung dargestellt und wird nachfolgend näher erläutert.

Es zeigen :

Figur 1 eine Schaltungsanordnung zur Überwachung zweier taktversetzt arbeitender Schaltwerke, deren Taktversorgung im Fehlerfall abgeschaltet wird, und

Figur 2 in mehreren Diagrammlinien verschiedene Schaltzustände der obengenannten Schaltungsanordnung.

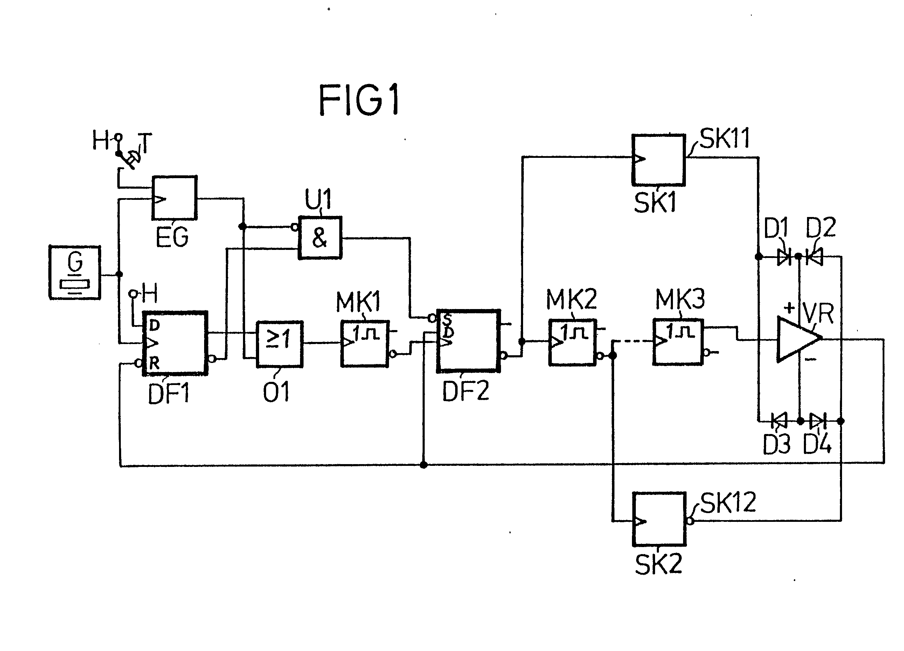

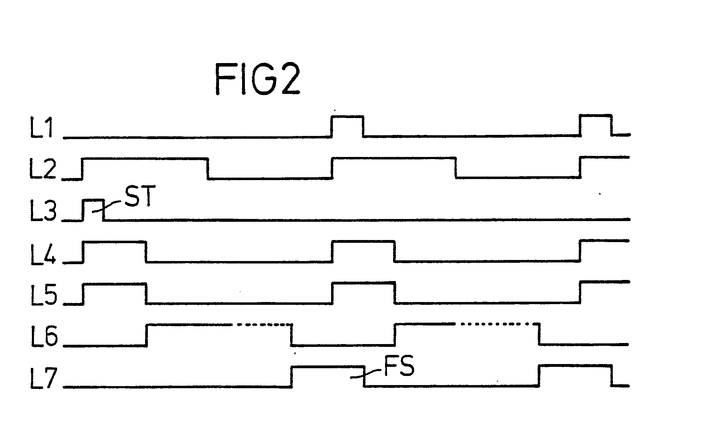

Das Schaltbild nach Figur 1 zeigt in Blockform zwei Schaltwerke SK1 und SK2, die gleiche Daten taktversetzt verarbeiten. Um das Wesentliche darzustellen, ist auf spezielle Datenquellen und Datensenken verzichtet worden. In der Regel benötigt jedes derartiger Schaltwerke wie z. B. Mikrocomputer, mehrere verschiedene Systemtakte ; beim Ausführungsbeispiel wird im Hinblick auf eine bessere Übersicht jedoch jeweils nur ein Taktpuls zugeführt. Die Erzeugung dieser Taktpulse erfolgt praktisch dadurch, daß zwei verschiedene Schaltungsteile mit eigenen Zeitnormalen über eine Torschaltung zusammen arbeiten und bei ordnungsgerechtem Betrieb eine Art Selbsthaltekreis bilden. Zu dem Zweck ist als erstes Zeitnormal ein Taktgenerator G vorgesehen, der ständig Taktimpulse an ein erstes D-Kippglied DF1 und an eine Startschaltung EG abgibt. Das zweite Zeitnormal ist praktisch durch ein mehrstufiges Register gegeben, welches aus einer vorgegebenen Anzahl von monostabilen Kippgliedern MK1, MK2 und MK3 besteht. Je nach Bedarf können es natürlich auch wesentlich mehr monostabile Kippglieder sein, die derart in Reihe geschaltet sind, daß sich die Zeiten der instabilen Schaltlagen addieren. Wesentlich ist noch für die Bemessung der Schaltung, daß die Periodendauer der vom Taktgenerator G abgegebenen Impulse der Gesamtlaufzeit des das zweite Zeitnormal darstellenden Registers entspricht. Hierdurch ist bei ordnungsgerechtem Betrieb der Schaltung gewährleistet, daß zu bestimmten Zeitpunkten ein sogenannter Fensterimpuls FS in Diagrammlinie L7 von Figur 2 zur Verfügung steht. Bei dessen Vorhandensein kann ein weiterer vom Taktgenerator G abgegebener Impuls vom Register übernommen werden. Nähere Einzelheiten hierzu werden später noch erläutert. Der genannte Fensterimpuls FS muß durch Bemessung des an letzter Stelle des mehrstufigen Registers vorgesehenen monostabilen Kippgliedes MK3 in seiner Dauer so bemessen sein, daß diese größer ist als die Summe der Laufzeittoleranzen des gesamten Registers. Durch diese Bemessung ist gewährleistet, daß beim Überschreiten der Summe der genannten Laufzeittoleranzen des Registers ein Abschaltvorgang eingeleitet wird, so daß die beiden Schaltwerke SK1 und SK2 keine Taktimpulse mehr erhalten. Dieser Zustand ist als sicher anzusehen, da dann weder über den Ausgang SK11 des Schaltwerkes SK1 noch über den negierten Ausgang SK12 des anderen Schaltwerkes SK2 dynamische Signale ausgegeben werden können.

An die Startschaltung EG ist mit seinem negierenden Eingang ein UND-Glied U1 sowie ein ODER-Glied 01 angeschlossen, dessen zweiter Eingang mit dem Ausgang des ersten D-Kippgliedes DF1 verbunden ist. An den negierten Ausgang des D-Kippgliedes DF1 ist der andere Eingang des UND-Gliedes U1 angeschlossen. Anstelle dieses verknüpfenden Schaltgliedes kann auch ein ODER-Glied mit negiertem Ausgang verwendet werden, das mit der Startschaltung EG und mit dem nicht negierten Ausgang des D-Kippgliedes DF1 verbunden wird. Der Ausgang des Schaltgliedes U1 ist mit dem negierten Setzeingang S eines zweiten D-Kippgliedes DF2 verbunden, dessen Takteingang an den negierten Ausgang des an erster Stelle des Registers liegenden monostabilen Kippgliedes MK1 angeschlossen ist. Dieses Kippglied MK1 ist widerum eingangsseitig mit dem ODER-Glied 01 verbunden. An den negierten Ausgang des D-Kippgliedes DF2 sind der Takteingang des Schaltwerkes SK1 sowie der Eingang des monostabilen Kippgliedes MK2 angeschlossen, dessen negierter Ausgang wiederum mit dem Takteingang des Schaltwerkes SK2 und dem Eingang des an letzter Stelle des Registers vorgesehenen Kippgliedes MK3 verbunden ist. Der Ausgang dieses Kippgliedes MK3 ist mit dem Eingang eines Verstärkers VR verbunden, dessen Stromversorgung über eine aus vier Dioden D1, D2, D3 und D4 gebildete Gleichrichterschaltung erfolgt. Diese ist einerseits mit dem Ausgang SK11 der Schaltwerkes SK1 und andererseits mit dem negierenden Ausgang SK12 des Schaltwerkes SK2 verbunden. Die Ausgänge SK11 und SK12 sind bezüglich einer abzugebenden Information bis auf die Negierung identisch. Dies bedeutet, daß nur bei ordnungsgerechtem Betrieb der beiden Schaltwerke SK1 und SK2 an der Gleichrichterschaltung eine Potentialdifferenz zur Verfügung steht, derart, daß unabhängig von deren Richtung die Stromversorgung des Verstärkers VR gewährleistet ist. Der Ausgang des Verstärkers VR, der bei ordnungsgerechtem Betrieb den obengenannten Fensterimpuls FS, vgl. Diagrammlinie L7 in Figur 2, führt, ist mit dem negierten R-Eingang des D-Kippgliedes DF1 sowie mit dem D-Eingang des D-Kippgliedes DF2 verbunden.

Die vorstehend beschriebene Schaltung kann dahingehend abgewandelt werden, daß für Schaltwerke mit mehreren Ausgängen diesen wie in der Schaltungsanordnung nach Figur 1 dargestellt ist, weitere Verstärker mit Gleichrichterschaltung zugeordnet werden. Bei einer derartigen Schaltung werden die Verstärker in Reihe geschaltet, so daß der Fensterimpuls FS zunächst alle in Reihe geschalteten Verstärker durchlaufen muß, um schließlich bei den beiden D-Kippgliedern DF1 und DF2 zu Steuerzwecken zur Verfügung zu stehen.

Nachfolgend wird nun die Wirkungsweise der gesamten Schaltungsanordnung näher erläutert.

Im abgeschalteten Zustand, bei dem für die beiden Schaltwerke SK1 und SK2 keine Taktimpulse zur Verfügung stehen, weist der Ausgang des Verstärkers VR L-Pegel auf. Dies hat zur Folge, daß das D-Kippglied DF1 gesperrt ist, auch wenn am D-Eingang ständig H-Pegel liegt. Während dieses einleitend angenommenen Schaltzustandes befinden sich ferner alle monostabilen Kippglieder MK1, MK2 und MK3 in der stabilen Schaltlage. Eine Übernahme von Impulsen aus dem ständig laufenden Taktgenerator G kann erst aufgrund eines Startvorganges mit Hilfe der Startschaltung EG erfolgen. Zu dem Zweck wird ein Tastenkontakt T, der auf H-Pegel liegt, kurzzeitig geschlossen ; vgl. Diagrammlinie L3, Impuls ST, der an die nachgeordneten Schaltglieder U1 und O1 abgegeben wird. Beim Vorliegen der Vorderflanke eines vom Taktgenerator G abgegebenen Impulses, vgl. Diagrammlinie L2, während des Vorhandenseins des Startimpulses ST wird das monostabile Kippglied MK1 über das ODER-Glied 01 in die instabile Lage gesteuert, vgl. Diagrammlinie L4. Ferner wird das D-Kippglied DF2 über das UND-Glied U1 gesetzt, da dessen Ausgang während des Startimpulses ST auf L-Pegel liegt, vgl. Diagrammlinie L5. Wenn nun das monostabile Kippglied MK1 wieder in seine stabile Lage zurückkehrt und vorher bereits der Startimpuls ST beendet ist, wird das D-Kippglied DF2 wieder in die andere Lage zurückgeschaltet. Dies ist dadurch möglich, daß der negierte S-Eingang des D-Kippgliedes DF2 zu jenem Zeitpunkt H-Pegel führt. Zum selben Zeitpunkt liegt ferner am D-Eingang des D-Kippgliedes DF2 immer noch L-Pegel. Das Ausgangssignal des D-Kippgliedes DF2 steht nun für das Schaltwerk SK1 zur Verfügung und schaltet ferner das monostabile Kippglied MK2 in dessen instabile Lage, vgl. Diagrammlinie L6. Nach einer für das monostabile Kippglied MK2 fest vorgegebenen Zeitspanne fällt dieses wieder in die stabile Lage zurück. Die dabei vorhandene Taktflanke steuert das Schaltwerk SK2 und das monostabile Kippglied MK3, vgl. Diagrammlinie L6.

In der praktischen Ausführung der Schaltungsanordnung nach Figur 1 wird zweckmäßigerweise eine Verzögerung derart vorgesehen, daß das monostabile Kippglied MK3 erst dann in den instabilen Zustand schaltet, wenn die beiden Schaltwerke SK1 und SK2 an ihren Ausgängen SK11 und SK12 eindeutige Zustände angenommen haben.

Das vom monostabilen Kippglied MK3 ausgegebene und vom Verstärker VR ausgegebene Signal dient als Fensterimpuls FS, vgl. Diagrammlinie L7, in dessen zeitlichen Bereich die nächste Vorderflanke des vom Taktgenerator G abgegebenen Signals fallen muß, wenn der obenerwähnte Selbsthaltekreis der Gesamtschaltung zustande kommen soll. Durch den Fensterimpuls FS liegt am negierten R-Eingang des D-Kippgliedes DF1 H-Pegel, so daß dieses gesetzt werden kan, vgl. Diagrammlinie L1. Tritt infolge einer Störung zwischen den beiden Zeitnormalen eine unerwünschte zeitliche Veränderung eine, so kann das D-Kippglied DF1 nicht gesetzt werden, da der Fensterimpuls FS in dem Fall entweder zu früh oder zu spät kommt. Bei ordnungsgerechtem Arbeiten wird nachfolgend wieder das D-Kippglied DF2 über das UND-Glied U1 bei dem dann am S-Eingang vorhandenen L-Pegel gesetzt. Ferner wurde beim Schalten des D-Kippgliedes DF1 das monostabile Kippglied MK1 über das ODER-Glied O1 in die instabile Lage geschaltet, vgl. Diagrammlinie L4. Vor dem Zurückfallen dieses monostabilen Kippgliedes MK1 in dessen stabile Lage muß der Fensterimpuls FS, vgl. Diagrammlinie L7 wieder aufgehört haben, so daß am D-Eingang des D-Kippgliedes DF2 wieder L-Pegel vorhanden ist. Beim Zurückfallen des monostabilen Kippgliedes MK1 in die stabile Lage wird das D-Kippglied DF2 wieder zurückgesetzt. Anschließend laufen Vorgänge an, die bereits beim Erläutern des Startvorganges beschrieben wurden.

Beim ordnungsgerechten Arbeiten beider Schaltwerke SK1 und SK2 sowie beim Einhalten vorgegebener Zeitbedingungen wird das aus den monostabilen Kippgliedern gebildete Register stets erneut über das D-Kippglied DF1 angestoßen. Auch ein Fehler im D-Kippglied DF1 würde dazu führen, daß die gesamte Taktversorgung unterbrochen wird. Ein selbsttätiger Wiederanlauf der Schaltung ist nicht möglich und kann nur durch die Startschaltung EG eingeleitet werden.

**Patentansprüche**

1. Schaltungsanordnung zur Überwachung von Schaltwerken, die in zwei Kanälen gleiche Daten taktversetzt verarbeiten und zu vorgegebenen Zeitpunkten über vergleichbare Ausgänge bei ordnungsgerechtem Betrieb gleiche Informationen abgeben, unter Verwendung einer Fehlererkennungsschaltung, die bei gestörtem Betrieb die Informationsausgabe verhindert, wobei die Fehlererkennungsschaltung mindestens einen Verstärker aufweist, dessen Stromversorgung über eine Gleichrichterschaltung erfolgt, die an einen Ausgang des einen Schaltwerkes und an den gleichen, jedoch negierten Ausgang des anderen Schaltwerkes angeschlossen ist, dadurch gekennzeichnet, daß die Taktversorgung beider Schaltwerke (SK1, SK2) über verschiedene Speicherglieder mindestens eines mehrstufigen Registers erfolgt, das ein eigenes Zeitnormal aufweist und über eine Torschaltung Impulse eines ein zweites Zeitnormal bildenden Taktgenerators (G) erhält, deren Periodendauer der Gesamtlaufzeit des Registers entspricht, wobei ein an letzter Stelle des Registers vorgesehenes Speicherglied (MK3) die Torschaltung über mindestens einen Verstärker (VR) der Fehlererkennungsschaltung mit Impulsen versorgt, deren Dauer größer ist als die Summe der Laufzeittoleranzen des Registers.

2. Schaltungsanordnung nach Anspruch 1, dadurch gekennzeichnet, daß das mehrstufige Register aus einer vorgegebenen Anzahl in Reihe geschalteter bistabiler Speicherglieder besteht, die durch eine das Zeitnormal bildende gesonderte Taktstromquelle fortschaltbar sind.

3. Schaltungsanordnung nach Anspruch 1, dadurch gekennzeichnet, daß das mehrstufige Register aus einer vorgegebenen Anzahl von monostabilen Kippgliedern (MK1, MK2, MK3) als Speicherglieder besteht, derart, daß sich die Zeiten der instabilen Schaltlagen addieren, und daß zwischen dem Taktgenerator (G) und das Register sowie zwischen das erste und zweite monostabile Kippglied (MK1, MK2) des Registers ein erstes bzw. zweites durch die über den Verstärker (VR) geführten Impulse steuerbares D-Kippglied (DF1, DF2) geschaltet ist, wobei das erste D-Kippglied (DF1) zusammen mit einer an den Taktgenerator (G) angeschlossenen Startschaltung (EG) über je ein verknüpfendes Schaltglied (U1, O1) das erste monostabile Kippglied (MK1) des Registers bzw. das zweite D-Kippglied (DF2) steuert.

## Claims

1. A circuit arrangement for monitoring switching mechanisms which, in two channels, process identical items of data with a clock-pulse offset and at predetermined times in the case of normal operation emit identical items of information via comparable outputs, using a fault recognition circuit which in the event of faulty operation prevents the information output, where the fault recognition circuit has at least one amplifier which is supplied with current via a rectifier circuit which is connected to one output of the first switching mechanism and to the same output, which however is negated, of the other switching mechanism characterised in that the clock-pulse supply to the two switching mechanisms (SK1, SK2) takes place via different storage elements of at least one multi-stage register which has its own time standard and, via a gate circuit, is fed with pulses of a clock-pulse generator (G) which forms a second time standard and whose period duration corresponds to the overall transit time of the register, where a storage element (MK3) arranged at the last location of the register supplies the gate circuit via at least one amplifier (VR) of the fault recognition circuit with pulses whose duration exceeds the sum of the transit time tolerances of the register.

2. A circuit arrangement as claimed in claim 1, characterised in that the multi-stage register comprises a predetermined number of series-connected bistable storage elements which can be stepped on by a special clock-pulse current source which forms the time standard.

3. A circuit arrangement as claimed in claim 1, characterised in that the multi-stage register comprises a predetermined number of monostable flip-flops (MK1, MK2, MK3) as storage elements, in such manner that the times of the unstable switching states are added, and that between the clock-pulse generator (G) and the register and between the first and second monostable flips-flops (MK1, MK2) of the register there is connected a first and second D flip-flop (DF1, DF2) respectively, which can be controlled by the pulses supplied via the amplifier (VR), where the first D flip-flop (DF1), together with start circuit (EG) which is connected to the clock pulse generator (G), controls the first monostable flip-flop (MK1) of the register and the second D flip-flop (DF2) in each case via a logic-linking switching element (U1, O1).

## Revendications

1. Circuit pour contrôler des dispositifs de commutation qui traitent, avec décalage de cadence, des données identiques dans deux canaux et qui émettent, à des instants prédéterminés et par l'intermédiaire de sorties comparables, des informations identiques dans le cas d'un fonctionnement correct, avec mise en œuvre d'un circuit d'identification d'erreurs qui empêche, en cas d'un fonctionnement perturbé, l'émission d'informations, le circuit d'identification d'erreurs comportant au moins un amplificateur dont l'alimentation en courant a lieu par l'intermédiaire d'un circuit redresseur qui est relié à une sortie du premier dispositif de commutation et à la même sortie, toutefois négativée, de l'autre dispositif de commutation, caractérisé par le fait que l'alimentation en signaux de cadence des deux dispositifs de commutation (SK1, SK2) s'opère par l'intermédiaire de différents éléments de mémorisation d'au moins un registre à étages multiples présentant une unité de temps normalisée qui lui est propre et recevant, par l'intermédiaire d'un circuit de porte, des impulsions d'un générateur de cadence (G) formant une seconde unité de temps normalisée dont la durée de la période correspond au temps total de fonctionnement du registre, un élément de mémorisation (MK3) qui est prévu au dernier emplacement de registre alimentant le circuit de porte par l'intermédiaire d'au moins un amplificateur (VR) du circuit d'identification d'erreurs, en impulsions dont la durée est supérieure à la somme des tolérances de la durée de transit du registre.

2. Circuit selon la revendication 1, caractérisé par le fait que le registre à plusieurs étages est constitué par un nombre prédéterminé d'éléments de mémoires bistables montés en série et qui peuvent être avancés par une source de courant de cadence distincte qui forme l'unité de temps normalisée.

3. Circuit selon la revendication 1, caractérisé par le fait que le registre à plusieurs étages est contrôlé par un nombre prédéterminé d'éléments de bascule monostables (MK1, MK2, MK3) servant d'éléments de mémorisation, et cela de telle manière que les durées des positions de commutation instables s'additionnent, et qu'entre le générateur de cadence (G) et le registre, de même qu'entre le premier élément et le second élément à bascule monostable (MK1, MK2) du registre est monté un premier et, respectivement, un second élément de bascule du type D (DF1, DF2) susceptible d'être commandé par des impulsions passant par l'amplificateur (VR), le premier élément à bascule du type D (DF1) commandant, avec un circuit de démarrage (EG) relié au générateur de cadence (G), et par l'intermédiaire de respectivement un dispositif de commutation combinatoire (U1, O1), le premier dispositif à bascule monostable (MK1) du registre ou le second élément à bascule du type D (DF2).

FIG1

# FIG2